# DEMANDE DE BREVET EUROPEEN

(11) **EP 1 225 539 A1**
(43) Date de publication de la demande: **24.07.2002**
(21) Numéro de dépôt: 02001383.5
(22) Date de dépôt: 30.05.2000
(51) Int. Cl.: G06K 19/077

(54) **Remplacement d'au moins une puce sur un support par enfoncement et recouvrement**

(30) Priorité: 15.06.1999 FR 9907550
(62) Demande divisionnaire de: 00938860.4
(71) Demandeur: GEMPLUS, 13420 Gemenos Cedex (FR)
(72) Inventeur: Fidalgo, Jean-Christophe, 13420 Gemenos (FR); Patrice, Philippe, 13011 Marseille (FR)

(57) **Abrégé**

L'invention vise la fabrication d'un dispositif comportant un support associé à au moins un microcircuit sous forme de puce, et comprend comprend le remplacement d'au moins une puce présentant un défaut soit au sein de celle-ci, soit au niveau de sa connexion à l'interface de communication ; est prévu de :
- enfoncer la puce à remplacer dans l'épaisseur du support de manière à ce que la surface supérieure de la puce affleure la surface (16a) du support ou se trouve légèrement en retrait de celle-ci et que sa connexion avec l'interface de communication soit rompue;
- prévoir un ensemble composé d'une puce mince de remplacement.

## Description

L'invention concerne un dispositif électronique comportant au moins une puce fixée sur un support et un procédé de fabrication d'un tel dispositif.

Dans certains domaines, dont celui des cartes à puce, il est nécessaire de réaliser le montage d'un microcircuit ou puce sur un support relativement mince et flexible. Dans le cas de cartes à puce, il est nécessaire d'une part que la présence de la puce n'occasionne pas une sur-épaisseur au-delà d'un seuil établi par des normes internationales (actuellement fixé à 50 µm) et d'autre part que le montage de la puce soit suffisamment sûr pour permettre une utilisation durable même lorsque la carte est soumise à des contraintes de pliage et de torsion relativement élevées.

De manière classique, on évite de créer une sur-épaisseur trop importante, en logeant la puce dans une cavité ménagée à cet effet dans l'épaisseur du support.

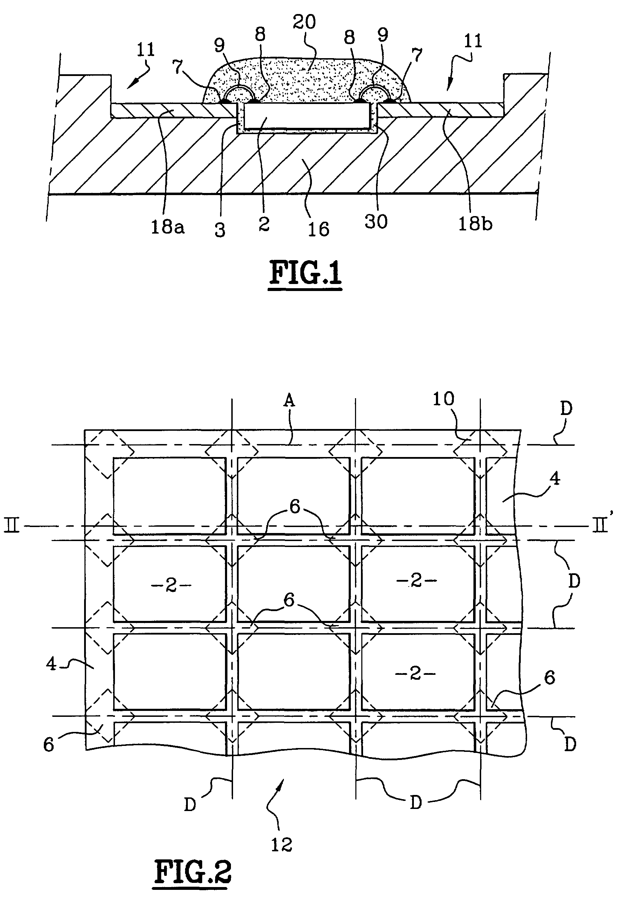

La figure 1 montre schématiquement un exemple connu de montage d'une puce sur un support 16 destiné à constituer une carte à puce. La puce est logée presque intégralement dans une cavité 30 de manière à ce que son épaisseur soit comprise dans celle du support 16. La puce présente un ensemble de plots de connexion 8 sur les bords de sa surface tournée vers l'extérieur de la cavité 30. Ces plots 8 sont reliés à des contacts respectifs 7 du support par des fils 9. Les contacts 7 peuvent être situés au fond de la cavité, ou à un niveau intermédiaire dans une zone de renfoncement 11 autour de la cavité, comme dans l'exemple illustré. Ces contacts 7 sont à leur tour reliés électriquement à des plages de contact 18a et 18b destinées à permettre une connexion ohmique avec un lecteur de cartes. Ces plages de contact sont logées intégralement dans le renfoncement 11 afin que leur épaisseur soit aussi contenue dans celle du support 16.

Pour protéger l'ensemble, on forme un enrobage de matériau protecteur 20 recouvrant toute la zone occupée par la cavité 30, les fils 9 et une portion des bords internes des plages de contact 18a et 18b.

Cette technique souffre de plusieurs inconvénients. Premièrement, l'opération consistant à relier électriquement les plots de connexion 8 de la puce 2 aux contacts 7 nécessite l'utilisation de fils 9 très fins est délicats, formant ainsi des points de fragilité. Par ailleurs, les opérations de soudage de ces fils 9 nécessitent un outillage important et un temps non négligeable.

Par ailleurs, la formation de la cavité 30 demande une étape d'usinage qui est à la fois coûteuse et fragilisante pour la carte.

On remarque aussi que cette technique basée sur l'intégration d'une puce dans une cavité d'un support est difficilement exploitable lorsqu'il est nécessaire de rassembler plusieurs composants, par exemple plusieurs puces ou autres éléments passifs ou actifs dans un même support.

Au vu de ces problèmes, l'invention propose une nouvelle approche pour la fabrication de dispositifs comportant au moins une puce montée sur un support. Aussi, l'invention a pour objets un procédé de fabrication et un dispositif comportant un support associé à au moins une puce, selon les revendications qui suivent.

L'invention met dans un exemple en oeuvre la technologie de puces réalisées en substrat très mince, telle que décrite notamment dans le document brevet WO-A-98/02921.

Le fait de créer au moins une partie de l'interface de communication seulement après le report d'un puce est particulièrement avantageux du point de vu des procédés de fabrication de tels dispositifs et de la sur épaisseur que présente l'ensemble puce et interface relativement au plan général de la face du support.

Ainsi, l'invention permet dans un exemple que la deuxième face soit reportée sur une portion de surface de la face du support qui est sensiblement dans le plan général de celle-ci.

Le procédé peut comporter en outre une étape de dépôt de couche protectrice sur au moins une partie exposée de la première face de la puce.

Il est possible de réaliser l'intégralité de l'interface de communication nécessaire pour le dispositif lors de l'étape de réalisation de l'interface de communication, celle-ci comportant au moins une plage de connexion et/ou au moins une interconnexion permettant de relier la puce à l'extérieur de celle ci.

En variante, au moins une partie de l'interface de communication comprenant une plage de connexion et/ou au moins une interconnexion permettant de relier la puce à l'extérieur de celle-ci est réalisée préalablement l'étape b) de report de la puce sur son support, l'étape d) consistant à réaliser au moins un lien de connexion ou amenée de courant, entre au moins un plot de la puce et une plage de connexion ou une interconnexion respective.

Selon un mode de réalisation préféré de l'invention, l'interface de communication est réalisée à l'étape d) par impression.

Cette impression peut être réalisée en une seule passe, par exemple par sérigraphie.

De préférence l'impression est réalisée avec une encre adhésive comportant une charge de particules conductrices.

La partie de l'interface de communication réalisée préalablement au report de la puce peut aussi être réalisée par sérigraphie.

Avantageusement, chaque plot de connexion (8) est réalisé sous forme de bossage sur ladite première face de la puce.

Citons le document FR-A-2760113 qui décrit une fabrication de carte mixte avec et / ou sans contact. Le corps de la carte comporte une ouverture de logement d'un module. Une dernière opération consiste à décoller une feuille adhésive faisant alors apparaître des contacts dénudés.

Le document DE-A-19735170 décrit une carte à plusieurs puces dont l'une est logée dans une cavité. Un cadre en cuivre est collé sur le support et délimite une matière de scellement (par dam & fill).

Le document FR-A-2747812 décrit un corps de carte, un circuit fixé dans une cavité et une antenne...déposée par sérigraphie sur le corps.

Notons aussi le document FR-A-2797203 décrit un die attach où il est "procédé à un chauffage local de la cavité puis une mise en place de la puce dans la matière thermoplastique ainsi fondue. Également, FR-A-2750250 décrit une insertion à chaud de la puce dans le substrat de module, dans le cadre de sa protection.

Dans un exemple, la puce est réalisée par une technologie dite de silicium sur isolant (SOI) et présente un épaisseur hors tout sensiblement égale ou inférieure à 10 µm.

L'invention se prête particulièrement bien à la réalisation de dispositifs comportant plusieurs puces sur un même support. Dans ce cas, l'étape (d) de réalisation d'au moins une partie de l'interface de communication peut être réalisée simultanément pour au moins un groupe parmi la pluralité de puces.

Selon un autre aspect de. l'invention, il est possible de réparer un dispositif par le remplacement sur le support d'au moins une puce présentant un défaut soit au sein de celle-ci, soit au niveau de sa connexion à l'interface de communication.

En effet, la très faible épaisseur de l'ensemble puce plus interface de communication obtenue grâce au procédé précité permet de remplacer une puce défectueuse par superposition d'une puce de remplacement au dessus de la puce où se situe le défaut.

L'invention sera mieux comprise à la lecture de la description qui suit d'exemples non-limitatifs, par référence aux dessins annexés dans lesquels :
- la figure 1 est une vue en coupe d'une carte à puce connue montrant l'emplacement d'une puce dans une cavité du support ;
- la figure 2 est un vue partielle en plan d'une plaquette issue de la technologie dite silicium sur isolant mise en oeuvre dans les modes de réalisation de l'invention ;
- la figure 3 est une vue en coupe selon l'axe II-II' de la figure 2 ;
- la figure 4 est une vue en coupe d'un ensemble comprenant une puce découpée de la plaquette représentée à la figure 2 et rapportée sur une face d'un support ;
- les figure 5a à 5c sont des vues en coupe représentant différentes étapes de la fabrication d'un dispositif selon un premier mode de réalisation de l'invention ;
- la figure 6 est une vue en plan d'une carte comportant plusieurs puces sur une même face conformément à un deuxième mode de réalisation de l'invention ; et
- les figures 7a à 7e sont des vues en coupe selon l'axe VI-VI' de la figure 6 représentant différentes étapes de la réparation d'un dispositif par remplacement de puce.

La figure 2 montre une plaquette 12 issue de la technologie dite silicium sur isolant (en anglais SOI pour "silicon on insulator"). Cette technologie permet de réaliser des puces 2 - c'est-à-dire la partie active du microcircuit - d'une très grande minceur. Les puces 2 sont disposées en lignes de rangées sur un substrat protecteur isolant 4, typiquement du verre, qui constitue la corps de la plaquette. Ce substrat isolant 4 sert entre autres à protéger les puces 2 qui sont souples en raison de leur minceur (de l'ordre de 10 µm).

Chaque puce 2 est retenue sur le substrat 4 par des plots d'adhésif 6. Ces plots d'adhésif 6 sont constitués par des petites aires rectangulaires, tournées à 45° par rapport aux côtés des puces 2 et placées sur les coins respectifs de chaque puce, de sorte qu'en dehors de la périphérie de la plaquette 12 un plot 6 recouvre quatre coins réunis de quatre puces différentes.

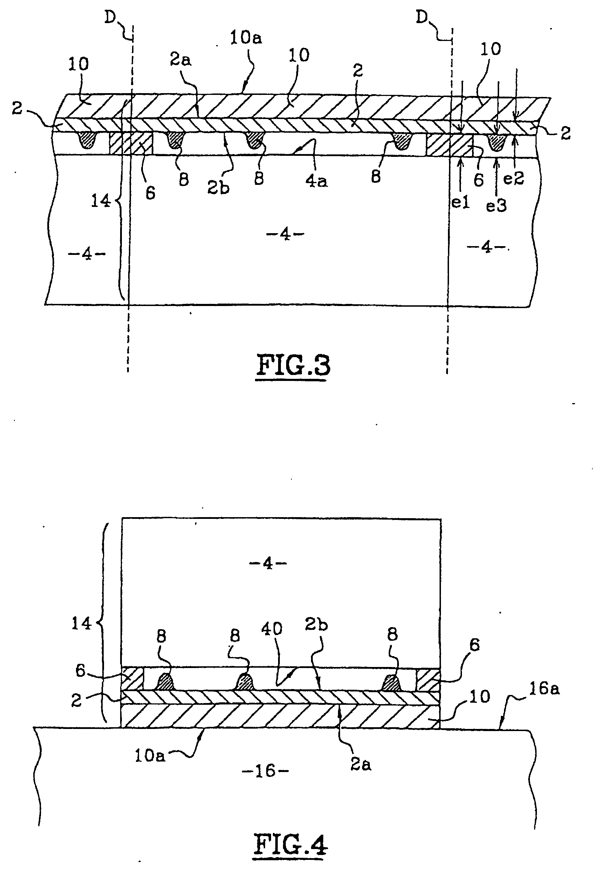

La figure 3 est une vue en coupe partielle selon l'axe II-II' de la figure 2 qui montre la structure d'un ensemble composé d'une puce 2, des plots d'adhésif 6 et du substrat de verre 4.

La puce 2 présente sur l'un ou plusieurs de ces bords des plots de connexion électrique qui permettent de relier le circuit réalisé sur la puce avec l'extérieur. Chaque plot de connexion 8 est réalisé par en bossage, connus plus généralement sous le terme anglo-saxon de "bump". Les bossages 8 de la puce 2 constituent des points en protubérance à partir de l'une des faces de la puce 2 permettant les interconnexions nécessaires.

Conformément à l'invention, les bossages 8 sont formés sur la face 2b de la puce 2 qui est tournée vers le substrat protecteur en verre 4. Chaque bossage 8 a une forme sensiblement ogivale permettant d'assurer un bon contact mécanique et électrique avec un plot correspondant au niveau de son interface.

L'épaisseur e1 des plots d'adhésif 6 est suffisante pour que le sommet des bossages 8 ne soit pas en contact avec la face 4a du substrat 4 qui lui est en regard.

On notera que la technologie SOI permet actuellement de réaliser des puces 2 dont l'épaisseur hors tout est de l'ordre de 10 µm, voire substantiellement moins. Cette dimension comprend d'une part l'épaisseur de l'ensemble de la surface de la puce 2 et d'autre part les surélévations au niveau des plots de connexion entre la puce et l'extérieur.

Dans l'exemple représenté à la figure 3, l'épaisseur e2 du corps de la puce 2 est par exemple de l'ordre de 5 µm et le relief e3 des bossages 8 est également de l'ordre de 5 µm.

La technologie SOI permettant l'obtention de puces avec de telles caractéristiques dimensionnelles est décrite notamment dans le document WO-A-9802921 au nom de la société KOPIN.

On applique une couche adhésive 10 sur la plaquette 12, avant la découpe de celle-ci, au niveau de la face exposée 2a de la puce 2, c'est-à-dire la face opposée à celle 2b tournée vers le substrat protecteur 4, comme le montre la figure 3.

Plusieurs techniques sont possibles pour réaliser cette couche adhésive 10.

Selon un mode de réalisation préféré de l'invention, la couche adhésive 10 est réalisée par lamination d'une fine pellicule de matériau thermofusible, connu sous le terme anglo-saxon de "hotmelt".

En variante, cette couche 10 peut être réalisée par sérigraphie à partir d'un vernis adhésif retravaillable à température, tel un matériau thermoplastique ou thermoscellable (également connue sous le terme anglo-saxon de "thermo set").

A titre d'exemple, l'épaisseur de la couche adhésive 10, quelque soit la technique par laquelle elle est réalisée, est entre m et n µm, une valeur typique étant de 10 µm.

Une fois la couche adhésive 10 déposée, on découpe la plaquette 12 le long des interstices D entre les lignes et rangées de puces (figures 1 et 3) afin d'obtenir des ensembles individuels 14 chacun au format d'une puce 2 et composé d'un substrat de verre 4, des plots d'adhésif 6 retenant une puce 2 sur les coins de celle-ci et la couche adhésive 10 recouvrant l'intégralité de la puce.

Il sera maintenant décrit comment au moins un tel ensemble 14 permet le montage de puce(s) sur une ou chaque face d'un support mince selon différents modes de réalisation.

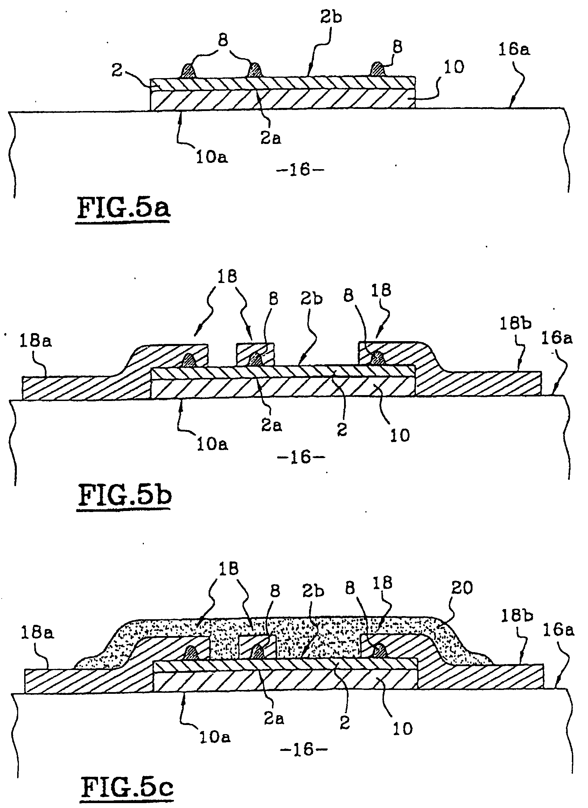

Dans un premier mode de réalisation, décrit par référence aux figures 4 et 5a-5c, l'ensemble 14 est déposé sur un support flexible 16 en matière plastique destiné à constituer le corps d'une carte à puce au format classique établi par la norme ISO 7810. Typiquement, le support peut être réalisé en résine ABS, PVC, PET.

Dans l'exemple illustré à la figure 4, le corps de la carte 16 est destiné à ne contenir qu'une seule puce 2 sur l'une 16a de ses faces pour former une carte dite "à contact".

En premier lieu, on présente l'ensemble 14 à l'emplacement du support 16 réservé pour le montage de la puce conformément à la norme précitée, avec la couche adhésive 10 tournée vers la face 16a destinée à recevoir la puce 2. De cette manière, l'ensemble 14 est collé sur le support 16 au niveau de la face 10a initialement exposée de la couche adhésive 10 (figure 4).

Une fois l'ensemble 14 fixement adhéré sur le support 16, on retire le substrat protecteur 4. Cette opération peut être réalisée par simple pelage du substrat 40. En effet, les points d'attache du substrat sur la puce par les quatre plots d'adhésif 6 (un à chaque coin) sont relativement faibles et leur rupture peut être provoquée par arrachement sans risque pour la fixation, bien plus solide, de la couche d'adhésif 10 sur la surface 16a du support.

Par ailleurs, lors du retrait du substrat de verre 4, les plots adhésifs 6 restent collés sur ce dernier, et sont donc également retirés de la surface 2b de la puce 2.

On obtient donc après le retrait du substrat 4 la configuration de la puce 2 collée sur une face 16a de son support 16, avec les bossages 8 tournés vers l'extérieur relativement à cette face 16a, tel que représenté à la figure 5a.

On remarquera que la puce 2 est montée, via la couche adhésive 10, directement sur la face principale 16a du support 16. Autrement dit, aucune cavité ou autre renfoncement n'est prévu sur la face 16a pour loger la puce 2. Ainsi, la couche adhésive 10 et la puce 2, ainsi que les bossages 8 viennent en sur épaisseur sur la face 16a. Dans l'exemple; l'épaisseur totale de la couche adhésive 10 et de la puce 2 ne dépasse pas 20 microns.

Ensuite, on imprime sur la surface exposée 2a de la puce 2 et sa périphérie une interface de communication 18 (figure 5b), L'interface de communication 18 constitue une couche électriquement conductrice présentant un motif permettant de relier chaque bossage 8 de la puce 2 vers une plage de contact de la carte à puce.

Dans l'exemple, l'étape d'impression de l'interface de communication 18 est réalisée en une seule étape de sérigraphie au moyen d'une composition chargée de particules conductrices (argent, cuivre, nickel ou autre). Cette composition comporte également. une charge de matériau adhésif afin de permettre une bonne tenue mécanique de l'interface de communication 18 sur la puce 2 et son support 16. L'interface de communication 18 forme ainsi une couche divisée sur le plan général du support 16 en plusieurs sections électriquement isolées les unes des autres. Chaque section recouvre un bossage respectif 8 et s'étend au-delà d'un bord de la puce 2 pour constituer sur la face 16a du support 16 une plage de contact correspondante 18a, 18b, permettant de s'engager avec des contacts d'un lecteur. Ainsi, chaque section de l'interface de communication imprimée 18 constitue un point de contact avec un bossage 8, une plage de contact 18a, 18b et une amenée de courant entre le bossage et la plage de contact.

Dans l'exemple, l'épaisseur de la couche d'impression 18 formant l'interface de communication est de l'ordre de 30 microns ou moins. De la sorte, la sur-épaisseur maximale de la carte à puce, située au niveau de l'empilement de la couche adhésive 10, la puce 2 et la couche de l'interface de communication 18, ne dépasse pas 50 microns. De ce fait, la carte ainsi réalisée est conforme aux normes ISO 7810 concernant la sur-épaisseur admissible.

On remarque que l'étape d'impression réalise l'intégralité des composantes de l'interface de communication, à savoir : la connexion avec bossages 8 de la puce 2, les plages 18a, 18b de contact avec un lecteur et les amenées de courant entre chaque bossage et sa plage de contact respective. Les plages de contact 18a, 18b sont réalisées en sur-épaisseur directement sur la face 16a du support formant la carte à puce.

En variante, il est possible de réaliser une ou plusieurs des composantes précitées de l'interface de communication à des étapes différentes.

Ainsi, on peut imprimer les plages de connexion 18a, 18b préalablement au report de la puce 2 et de sa couche adhésive 10 sur le support 16. Dans ce cas, l'opération d'impression décrite par référence à la figure 5b consiste à imprimer seulement la connexion avec les bossages 8 de la puce 2 et les amenées de courant respectives reliant celles-ci aux plages de contact 18a, 18b préalablement imprimées sur le support 16.

Lorsque les plages de contact sont ainsi réalisées préalablement au report de la puce 2, elles peuvent être formées selon une technique autre que l'impression, par exemple la métallisation par dépôt.

Cette variante permet de retarder le report de la puce dans le processus de fabrication du dispositif afin de ne pas être pénalisé par les rebuts de l'opération de réalisation des plages de contact.

Quelque soit la variante, il est possible de réaliser l'impression de l'interface de communication (ou une partie de celle-ci) en plusieurs passages de sérigraphie, en fonction du motif requis.

Enfin, on peut prévoir une fine pellicule protectrice 20 recouvrant la puce et une partie de l'interface de communication au niveau des amenées de courant, à proximité des bords de la puce. Cette couche protectrice 20 peut être déposée directement sous forme de film mince, ou elle peut être réalisée par pulvérisation d'un agent en phase liquide, tel qu'un vernis. L'épaisseur de la pellicule protectrice peut ainsi rester inférieure à une dizaine de microns, ce qui permet le respect des normes en ce qui concerne la sur-épaisseur admissible.

Bien entendu, il est également possible de réaliser par la même technique une interface de communication permettant de relier au moins un bossage 8 de la puce 2 à au moins un élément électrique intégré à la carte, l'élément pouvant être toute combinaison parmi :
- une antenne permettant d'échanger des données entre la puce 2 et un lecteur par voie hertzienne pour réaliser une carte sans contact, l'antenne pouvant par ailleurs capter de l'énergie électrique pour alimenter la puce ;
- au moins un composant passif tel qu'une résistance, un inducteur ou un condensateur, formant par exemple un circuit LC ;
- au moins un composant actif, tel un affichage, une source d'énergie (par exemple un cellule solaire), etc. ; et
- au moins une autre puce, celle-ci pouvant être montée sur le support 16 de la carte selon la technique utilisée pour la puce 2.

On remarquera que grâce au fait que le procédé permet de ne pas déposer la puce dans une cavité, on peut réaliser des connexions sans être gêné par la différence de hauteur entre la puce et les plages de contact à connecter.

Ce principe permet également de réaliser une carte avec des puces de grandes dimensions, du type microprocesseur ou autre, ce qui n'est pas possible avec la technologie des puces reportées selon la technologie MOSAIC.

Il sera maintenant décrit un deuxième mode de réalisation de l'invention dans lequel les techniques précédemment décrites sont utilisées pour la réalisation d'un module comportant plusieurs puces sur un même support.

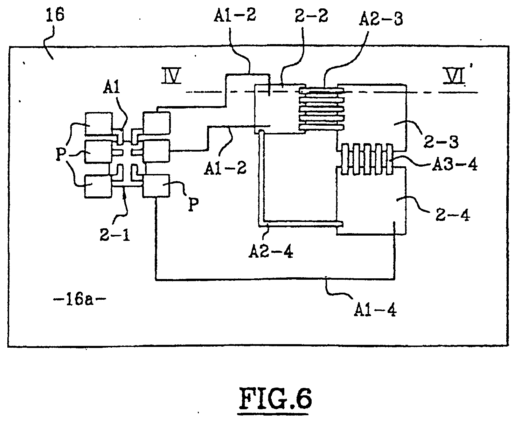

Dans l'exemple illustré à la figure 6, qui représente en vue de plan un dispositif après fabrication, le support 16 est également destiné à constituer une carte à puce, la carte comportant ici quatre puces interconnectés sur une même face 16a. Ce type de carte à plusieurs puces est généralement connu sous le terme anglo-saxon de "multi- chip module".

Une première puce 2-1 regroupe l'ensemble des plages de connexion P servant à réaliser l'interface avec un lecteur à contact. Cette puce 2-1 et les plages de connexion P qui l'entourent sont donc situées à l'emplacement du support prévu pour la connexion avec un lecteur. Le lecteur est prévu pour établir un contact ohmique avec les plages P pour échanger des données avec la carte.

La première puce 2-1 est reliée à trois autres puces 2-2, 2-3 et 2-4 par un ensemble d'interconnexions, chaque interconnexion reliant un bossage d'une puce à un bossage d'une autre. Dans la figure 6, ces interconnexions sont désignées par la lettre A suivi de deux chiffres séparés par un tiret, ces derniers désignant respectivement le dernier chiffre de référence des puces reliées par l'interconnexion.

Les interconnexions A1-2 et A1-4 relient respectivement une puce 2-2 et 2-4 directement à une plage de contact P qui entoure la première puce 2-1.

Chaque puce 2-1 à 2-4 est réalisée sous forme de plaquette respective avec les caractéristiques décrites par référence aux figures 2 et 3 (on suppose ici que ces puces sont toutes différentes). A l'instar du premier mode de réalisation, les bossages des puces sont réalisées sur la face 2b tournée vers le substrat protecteur 4.

Les plaquettes précitées sont recouvertes d'une couche adhésive 10 telle que décrite par référence à la figure 3.

Elles sont ensuite découpées en ensembles de puces individuelles 14 comportant chacun un substrat 4 aux dimensions de la puce, la puce 2-1, ..., ou 2-4, les plots d'adhésif 6 et la couche adhésive 10 aux coins de la puce, comme décrit par référence à la figure 4.

Chaque ensemble est reporté sur la surface du support 16, à l'emplacement prévu pour la puce correspondante, avec la couche adhésive 10 en contact avec la face 16a du support, comme décrit par référence à la figure 5.

Ainsi, pour le présent exemple, les quatre puces auront été reportées et collées sur la face 16a du support aux emplacements indiqués.

Le substrat protecteur 4 de chaque ensemble est ensuite enlevé de la manière décrite par référence à la figure 5a. Cette opération de retrait des substrats 4 peut s'effectuer simultanément une fois que tous les ensembles 14 sont reportés sur le support 16.

Une fois les substrats retirés, on procède à l'impression de l'interface de communication, celle-ci comprenant l'ensemble des plages de connexion P destiné à entrer en contact avec un lecteur, les amenées de courant A1 pour la puce 2-1 et les interconnexions A1-2, A2-3, A3-4 et A1-4.

L'interface de communication est réalisée selon la technique décrite par référence à la figure 5b et autorise les même variantes que celles mentionnées à propos ce cette figure.

Dans l'exemple, l'intégralité de l'interface de communication est réalisée par impression sérigraphique directement sur les bossages des puces 2-1 à 2-4 et sur la surface 16a du support 16. Cette impression est réalisée en une seule passe au moyen d'une encre conductrice et adhésive chargée de particules d'argent. Ainsi, chaque puce présente une métallisation au niveau des bossages de contact dont le profil est analogue à celui représenté à la figure 5b.

Il est également possible de fractionner la réalisation de l'interface de communication en plusieurs étapes, dont au moins une peut intervenir. avant le report des puces. Ceci peut être notamment le cas pour les plages de contact P et/ou certaines interconnexions, par exemple celles A2-3 et A3-4 qui comprennent plusieurs pistes rapprochées. Ainsi, tout défaut de fabrication au niveau de ces parties de l'interface de communication peut être constaté avant le report de puces.

Après le retrait des substrats protecteurs de verre 4, on dépose sur l'ensemble des puces et des interconnexions une fine couche protectrice comme la pellicule 20 décrite par référence à la figure 5c.

Un tel assemblage de plusieurs puces sur un même support, en l'occurrence un support souple, permet de fabriquer des circuits de grande complexité, notamment un ordinateur personnel, sur des formats réduits. A titre d'exemple, une carte unique peut comprendre un microprocesseur, un afficheur et son circuit de commande, le tout interconnecté.

Il sera maintenant décrit un autre aspect de la présente invention selon lequel il est possible d'effectuer une réparation par remplacement d'une ou de plusieurs puces détectée(s) comme étant défectueuse(s) après leur report sur l'interface de communication.

Cet aspect sera décrit pour le cas de la réalisation d'un circuit à puces multiples telle que décrite et représentée à la figure 6. Toutefois, elle peut aussi s'appliquer de manière analogue pour les cartes à une seule puce.

A titre d'illustration, on suppose qu'une carte ainsi composée de quatre puces 2-1 à 2-4 dans un lot de fabrication s'avère défectueuse lors d'un contrôle en fin de fabrication.

Des tests permettent de localiser la ou les puce(s) en cause en fonction du comportement de l'ensemble. Dans le cadre de l'exemple, un test détermine que le défaut concerne le fonctionnement de la puce 2-3 (figure 6). Le défaut peut se situer soit au niveau de la puce même, celle-ci n'ayant pas été préalablement testée ou ayant été endommagée ultérieurement, soit au niveau des interconnexions entre les bossages de la puce 2-3 et son interface de communication.

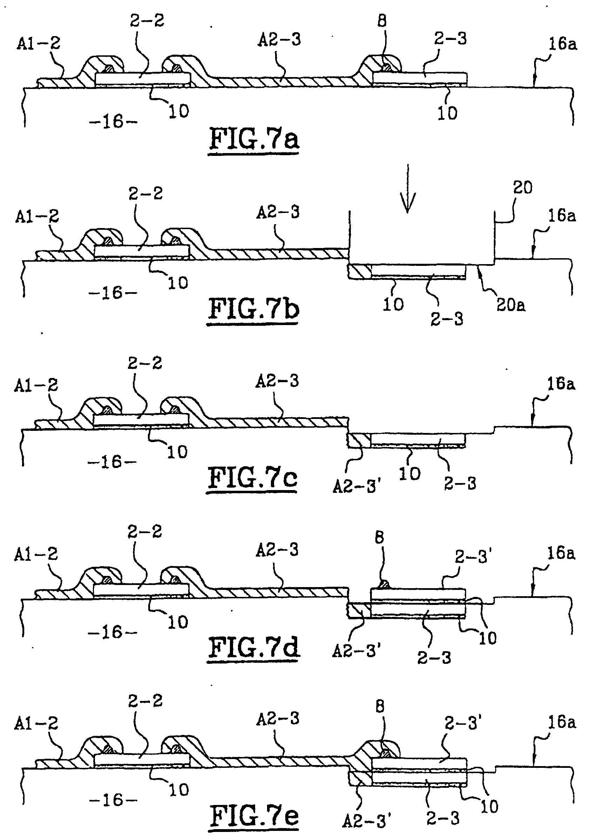

La figure 7a est une vue en coupe selon l'axe VI-Vl' de la figure 6. On retrouve les puces 2-2 et 2-3 sur la face 16a du support 16, l'interconnexion A2-3 reliant ces deux puces sur des bossages respectifs 8 et une portion de l'interconnexion A1-2 qui relie la puce 2-2 à l'une des plages de contact P autour de la puce 2-1.

Pour remplacer la puce défectueuse 2-3, on procède initialement à l'emboutissage de celle-ci par un poinçon 20 présentant une face d'emboutissage 20a au format de la puce 2-3, ou légèrement supérieur (figure 7b). La face d'emboutissage 20a du poinçon 20 peut être chauffante afin de créer une fusion de la matière ou engendrer un phase plastique de celle-ci. Le poinçon 20 enfonce la puce défectueuse 2-3 ainsi que la partie de l'interconnexion A2-3 autour du bossage 8 dans l'épaisseur du support de la carte 16. A l'issue de cette opération, la puce défectueuse 2-3 est entièrement encastrée dans le support 16, la surface supérieure de la puce 2-3 et de la partie de l'interconnexion A2-3 autour du bossage 8 affleurant la surface 16a du support. La surface supérieure précitée peut éventuellement être légèrement en retrait de la surface 16a du support, comme représenté à la figure 7c. On remarque que l'emboutissage assure la rupture de l'interconnexion A2-3 autour de bossage 8. De la sorte, la puce défectueuse 2-3 devient électriquement isolée des autres éléments de la carte.

On reporte à l'emplacement initial de la puce défectueuse une nouvelle puce de remplacement 2-3' selon la même technique que pour le report des autres puces, telle que décrite par référence aux figures 4 et 5a. Ainsi, la couche adhésive 10 associée à la puce de remplacement 2-3' est mise en contact avec la surface supérieure de la puce emboutie 2-3 (figure 7d). La puce de remplacement 2-3' se trouve alors au même niveau que la puce défectueuse 2-3 avant qu'elle ne soit emboutie, ou légèrement en dessous de ce niveau.

Ensuite, on procède à l'impression de la ou de chaque portion de l'interconnexion A2-3 qui relie un bossage 8 correspondant de la puce de remplacement 2-3' (figure 7e). L'impression de cette portion de l'interconnexion peut être réalisée selon les mêmes techniques que pour l'interface de communication. De préférence, la portion nouvellement imprimée dépasse légèrement les limites de surface emboutie par le poinçon 20 afin d'assurer une bonne continuité avec la partie principale de l'interconnexion.

Bien entendu, la technique de remplacement de puce défectueuse peut s'appliquer à tout autre puce ou plusieurs puces sur l'une ou l'autre des faces.

Il est clair que le cadre de l'invention dépasse largement du domaine des cartes à puce et s'applique à tout circuit ou ensemble réalisé par report d'une ou de plusieurs puces sur un support, notamment un support souple tel qu'une carte, un film, etc...

Par ailleurs, toute combinaison décrite relativement à un mode de réalisation ou une variante s'applique également à un autre mode de réalisation dès lors qu'elle est techniquement réalisable.

## Revendications

1. Procédé de fabrication d'un dispositif comportant un support associé à au moins un microcircuit sous forme de puce, **caractérisé en ce qu'**il comprend le remplacement d'au moins une puce présentant un défaut soit au sein de celle-ci, soit au niveau de sa connexion à l'interface de communication ; ce procédé comportant les étapes consistant à :
- enfoncer la puce à remplacer dans l'épaisseur du support de manière à ce que la surface supérieure de la puce affleure la surface (16a) du support ou se trouve légèrement en retrait de celle-ci et que sa connexion avec l'interface de communication soit rompue;
- prévoir un ensemble composé d'une puce mince de remplacement retenue par une première face à un substrat protecteur et présentant sur cette première face au moins un plot de connexion (8), et répéter pour cette puce de remplacement d'étapes prévoyant b) de reporter le ensemble sur une face (16a) du support, avec une deuxième face de la puce, opposée à la première, en regard de la face du support, c) retirer le substrat protecteur afin d'exposer la première face de la puce et d) réaliser au moins une partie d'une interface communication recouvrant la première face de la puce au niveau d'au moins un plot de connexion et une portion de surface (16a) du support.

2. Procédé selon la revendication 1, **caractérisé en ce qu'**il comporte une étape a) préalable à l'étape b) qui prévoir initialement pour la puce un ensemble composé d'une puce mince retenue par une première face à un substrat protecteur et présentant sur cette première face au moins un plot de connexion (8).

3. Procédé selon la revendication 2, **caractérisé en ce que** la deuxième face est reportée sur une portion de surface de la face qui est sensiblement dans le plan général de celle-ci.

4. Procédé selon la revendication 2 ou 3, **caractérisé en ce qu'**il comporte en outre à l'étape a) la fait de prévoir une couche adhésive sur la deuxième face de la puce permettant de coller celle-ci sur la face du support lors de l'étape b).

5. Procédé selon l'une des revendications 2 à 4, **caractérisé en ce que** qu'il comporte en outre une étape de dépôt de couche protectrice sur au moins une partie exposée de la première face de la puce.

6. Procédé selon l'une des revendications 2 à 5, **caractérisé en ce que** l'on réalise l'intégralité de l'interface de communication nécessaire pour le dispositif lors de l'étape de réalisation de l'interface de communication, celle-ci comportant au moins une plage de connexion (P) et/ou au moins une interconnexion permettant de relier la puce à l'extérieur de celle ci.

7. Procédé selon l'une des revendications 2 à 5, **caractérisé en ce qu'**au moins une partie de l'interface de communication comprenant une plage de connexion (P) et/ou au moins une interconnexion permettant de relier la puce à l'extérieur de celle-ci est réalisée préalablement l'étape b) de report de la puce sur son support, l'étape d) consistant à réaliser au moins un lien de connexion entre au moins un plot de la puce et une plage de connexion ou une interconnexion respective.

8. Procédé selon l'une des revendications 2 à 7, **caractérisé en ce que** l'interface de communication est réalisée à l'étape d) par impression.

9. Procédé selon la revendication 8, **caractérisé en ce que** l'étape d'impression est réalisée en une seule passe.

10. Procédé selon l'une des revendications 8 ou 9, **caractérisé en ce que** l'impression est réalisée par sérigraphie.

11. Procédé selon l'une quelconque des revendications 8 10 **caractérisé en ce que** l'impression est réalisée avec une encre adhésive comportant une charge de particules conductrices.

12. Procédé selon l'une des revendications 7 à 11, **caractérisé en ce que** la partie de l'interface de communication réalisée préalablement au report de la puce est réalisée par sérigraphie.

13. Procédé selon l'une des revendications 1 à 12, **caractérisé en ce que** chaque plot de connexion (8) est réalisé sous forme de bossage sur la première face de la puce.

14. Procédé selon l'une des revendications 1 à 13, **caractérisé en ce que** la puce est réalisée par une technologie dite de silicium sur isolant (SOI) et présente un épaisseur hors tout sensiblement égale ou Inférieure à 10 µm.

15. Procédé selon l'une des revendications 1 à 14 pour la réalisation de dispositifs comportant une pluralité de puces interconnectées, **caractérisé en ce que** l'étape d) de réalisation d'au moins une partie de l'interface de communication est réalisée simultanément pour au moins un groupe parmi la pluralité de puces.

16. Dispositif tel qu'une carte à puce, étiquette électronique, etc, comportant un support associé à au moins un microcircuit sous forme de puce ; **caractérisé en ce qu'**il comprend, sur au moins une des faces du support, au niveau de la ou chaque puce :
- la puce présentant une première face, tournée vers l'extérieur vis-à-vis du support, comportant au moins un plot de connexion et une seconde face collée à la face du support; et
- une interface de communication recouvrant au moins un plot de connexion sur la première face de la puce et une portion de la face du support.

17. Dispositif selon la revendication 16, , fabriqué selon le procédé de l'une des revendications 1 à 15 ; **caractérisé en ce qu'**il comporte en outre une couche protectrice sur au moins la première face de la puce.

18. Dispositif selon la revendication 16 ou 17, et fabriqué selon le procédé de l'une des revendications 1 à 15 ; **caractérisé en ce que** la surface au dessus de la puce présente une sur épaisseur relativement au plan général de la face du support sensiblement égale ou inférieure à 50 µm.
